# EUROPEAN PATENT APPLICATION

(11) **EP 2 315 275 A1**
(43) Date of publication of application: **27.04.2011**
(21) Application number: 10177132.7
(22) Date of filing: 16.09.2010
(51) Int. Cl.: H01L 33/38, H01L 33/44

(54) **Light emitting device, method of manufacturing the same, light emitting device package, and lighting system**

(30) Priority: 21.10.2009 KR 20090100070
(71) Applicant: LG Innotek Co., Ltd., Seoul 100-714 (KR)
(72) Inventor: Bae, Jung Hyeok, 100-714 Seoul (KR); Jeong, Young Kyu, 100-714, Seoul (KR); Park, Kyung Wook, 100-714 Seoul (KR)
(74) Representative: Cabinet Plasseraud

(57) **Abstract**

A light emitting device includes a light emitting stack structure including a first conductive semiconductor layer (30), a second conductive semiconductor layer (50), and an active layer (40) between the first and second conductive semiconductor layers; a passivation layer (70) at least partially on the light emitting stack structure; a first electrode (91) on the first conductive semiconductor layer; and a second electrode (92) on the first electrode and the passivation layer.

## Description

### BACKGROUND

The embodiment relates to a light emitting device, a method of manufacturing the same, a light emitting device package, and a lighting system.

A light emitting diode (LED) has been extensively used as a light emitting device.

The LED has a stack structure including a first conductive semiconductor layer, an active layer, and a second conductive semiconductor layer, and emits light through the active layer as power is applied thereto.

Recently, the brightness of the LED has been increasing, so that the LED can be employed as a light source for a display device, a vehicle, or a lighting device. In addition, the LED can emit white color having superior light efficiency by employing phosphors or by combining LEDs having various colors.

Meanwhile, the brightness of the LED can be changed according to various conditions such as an active layer structure, a light extraction structure for extracting light to the outside, a chip size, and type of molding members surrounding the LED.

### SUMMARY

The embodiment provides a light emitting device having a novel structure, a method of manufacturing the same, a light emitting device package, and a lighting system.

The embodiment provides a light emitting device having improved light extraction efficiency, a method of manufacturing the same, a light emitting device package, and a lighting system.

A light emitting device according to the embodiment includes a light emitting structure including a first conductive semiconductor layer, a second conductive semiconductor layer, and an active layer between the first and second conductive semiconductor layers; a passivation layer at least partially on the light emitting structure; a first electrode on the first conductive semiconductor layer; and a second electrode on the first electrode and the passivation layer.

A light emitting device package according to the embodiment includes a body; first and second package electrode layers on the body; a light emitting device electrically connected to the first and second package electrode layers on the body; and a molding member surrounding the light emitting device on the body, wherein the light emitting device includes a light emitting structure including a first conductive semiconductor layer, a second conductive semiconductor layer, and an active layer between the first and second conductive semiconductor layers; a passivation layer at least partially on the light emitting structure; a first electrode on the first conductive semiconductor layer; and a second electrode on the first electrode and the passivation layer.

A lighting system according to the embodiment includes a light emitting module including a substrate and at least one light emitting device installed on the substrate as a light source, wherein the light emitting device includes a light emitting structure including a first conductive semiconductor layer, a second conductive semiconductor layer, and an active layer between the first and second conductive semiconductor layers; a passivation layer at least partially on the light emitting structure; a first electrode on the first conductive semiconductor layer; and a second electrode on the first electrode and the passivation layer.

A method of manufacturing a light emitting device according to the embodiment includes the steps of forming a light emitting structure on a substrate; forming a passivation layer on the light emitting structure; selectively removing the passivation layer on the light emitting structure; forming a first electrode on the light emitting structure at least at the selectively removed portion of the passivation layer; and forming a second electrode on the first electrode and the passivation layer.

### BRIEF DESCRIPTION OF THE DRAWINGS

FIG. 1 is a sectional view of a light emitting device according to an embodiment;
FIG. 2 is a partially cut-away perspective view of the light emitting device according to the embodiment;
FIG. 3 is a plan view showing a first electrode formed on a first conductive semiconductor layer of the a light emitting device according to the embodiment;
FIG. 4 is a plan view showing a second electrode formed on a passivation layer of the a light emitting device according to the embodiment;
FIGS. 5 to 13 are sectional views showing the procedure for manufacturing a light emitting device according to the embodiment;
FIG. 14 is a sectional view of a light emitting device package including a light emitting device according to the embodiment;
FIG. 15 is an exploded perspective view of a backlight unit including a light emitting device or the light emitting device package according to the embodiment; and
FIG. 16 is a perspective view of a lighting unit including a light emitting device or a light emitting device package according to the embodiment.

### DETAILED DESCRIPTION OF THE EMBODIMENTS

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" on the other substrate, layer (or film), region, pad, or pattern, or one or more intervening layers may also be present. Such a position of the layer has been described with reference to the drawings.

The thickness and size of each layer shown in the drawings may be exaggerated, omitted or schematically drawn for the purpose of convenience or clarity. In addition, the size of elements does not utterly reflect an actual size.

Hereinafter, a light emitting device, a method of manufacturing the same, a light emitting device package, and a lighting system according to the embodiments will be described in detail with reference to accompanying drawings.

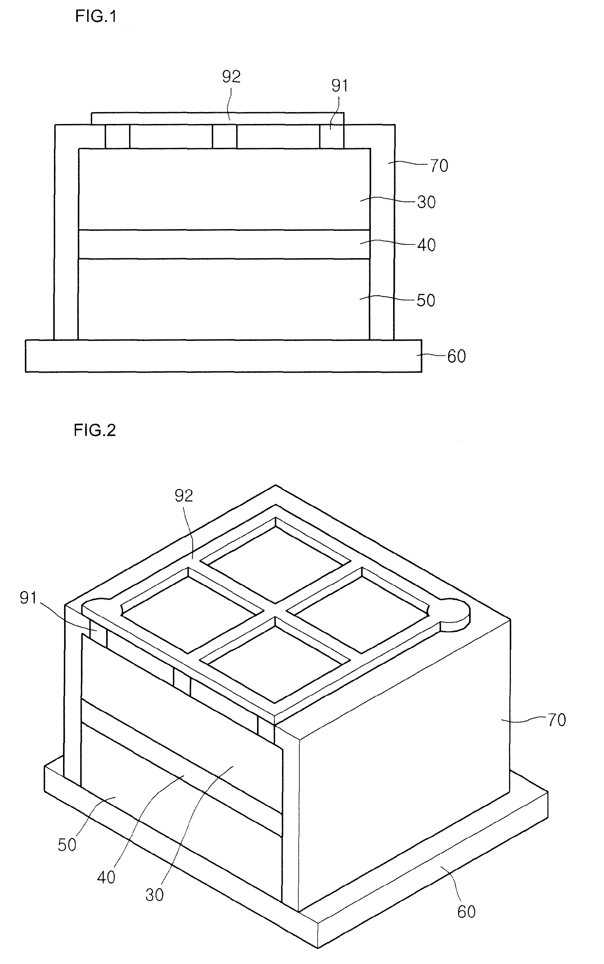

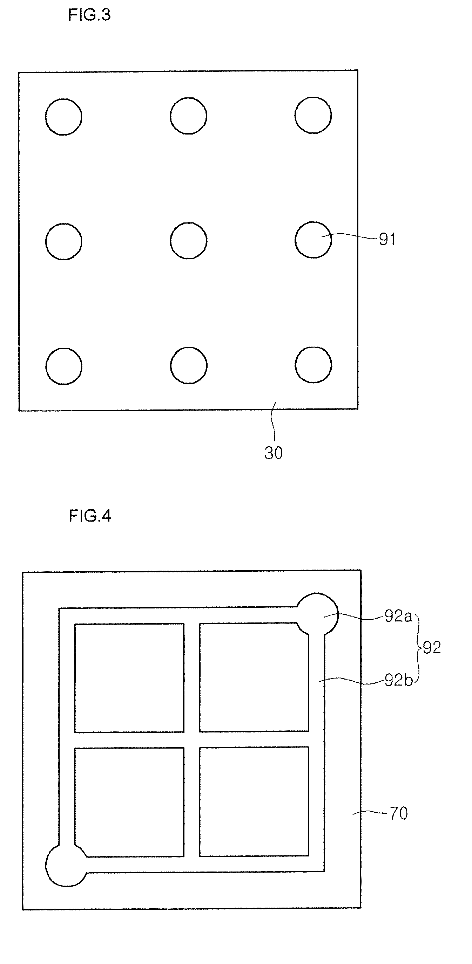

FIG. 1 is a sectional view of a light emitting device according to an embodiment, FIG. 2 is a partially cut-away perspective view of the light emitting device according to the embodiment, FIG. 3 is a plan view showing a first electrode formed on a first conductive semiconductor layer of the light emitting device according to the embodiment, and FIG. 4 is a plan view showing a second electrode formed on a passivation layer of the light emitting device according to the embodiment.

Referring to FIGS. 1 and 2, the light emitting device according to the embodiment includes a light emitting structure having a second conductive semiconductor layer 50, an active layer 40 and a first conductive semiconductor layer 30, which are formed on a conductive support substrate 60, and a passivation layer 70 surrounding a top surface and lateral sides of the light emitting structure.

A first electrode 91 is formed on a region of the first conductive semiconductor layer 30 where the passivation layer 70 is selectively removed, and a second electrode 92 is formed on the first electrode 91 and the passivation layer 70.

According to the light emitting device of the embodiment, the first electrode 91 is disposed on the first conductive semiconductor layer 30 and the second electrode 92 is formed on the first electrode 91.

The first electrode 91 may directly make contact with the first conductive semiconductor layer 30 and the second electrode 92 may directly make contact with the first electrode 91.

The first electrode 91 is formed on the first conductive semiconductor layer 30 covering a first area and the second electrode 92 is formed on the first electrode 91 and the passivation layer 70 covering a second area that is larger than the first area.

At least a part of the first electrode 91 overlaps the second electrode 92 so that the first electrode 91 is electrically connected to the second electrode 92. For instance, as shown in FIG. 1, the second electrode 92 may cover the first electrode 91 and the passivation layer 70 adjacent to the first electrode 91.

At least one first electrode 91 is formed on the first conductive semiconductor layer 30.

If only one first electrode 91 is formed on the first conductive semiconductor layer 30, the second electrode 92 may cover a greater area of the first electrode 91.

If a plurality of first electrodes 91 are formed on the first conductive semiconductor layer 30, the second electrode 92 is arranged such that all first electrodes 91 are electrically connected with each other by the second electrode 92 and at least one of the first electrodes 91 may be completely covered with at least a part of the second electrode 92.

As shown in FIG. 3, the plurality of the first electrodes 91 may be formed on the first conductive semiconductor layer 30. In this case, as shown in FIG. 4, the second electrode 92 is arranged such that the plurality of the first electrodes 91 may be electrically connected with each other by the second electrode 92. Referring to FIG. 4, the second electrode 92 may have a configuration in the form of a combination of circles and lines. In this case, circular sections 92a of the second electrode 92 make contact with the first electrode 91 and linear sections 92b of the second electrode 92 extend from the circular section 92a of the second electrode 92.

The linear sections 92b of the second electrode 92 electrically connect the first electrodes 91 with each other, and the circular section 92a of the second electrode 92 may completely cover the first electrode 91 to facilitate wire connection.

At least a part of the first electrode 91 may be aligned on the same horizontal plane with the passivation layer 70 and may make contact with the passivation layer 70.

In addition, at least a part of the second electrode 92 makes contact with the top surface of the passivation layer 70.

According to the light emitting device of the embodiment, the area of the first electrodes 91 covering the first conductive semiconductor layer 30 is minimized, and the second electrode 92 is formed on the first electrodes 91 to electrically connect the first electrodes 91 with each other by facilitating as wire connection.

If the first electrodes 91 are formed on the first semiconductor layer 30 covering a large area, resistance can be reduced and current spreading effect can be achieved. However, the first electrodes 91 formed on the first conductive semiconductor layer 30 absorb light emitted from the active layer 40 so that the light extraction efficiency of the light emitting device may be reduced.

Therefore, according to the embodiment, the second electrode 92 is formed on the first electrode 91 and the passivation layer 70 so that the second electrode 92 may be further spaced apart from the first conductive semiconductor layer 30 or the active layer 40 by the thickness of the passivation layer 70. As a result, light loss due to the absorption or reflection of the light by the second electrode 92 may be reduced, so that the light extraction efficiency may be improved.

A simulation test was performed by taking an overlap area between the first conductive semiconductor layer and the electrode under simulation. According to the simulation test, the light emitting device of the embodiment in which the first electrode 91 and the passivation layer 70 are formed on the first conductive semiconductor layer 30 and the second electrode 92 is formed on the first electrode 91 and the passivation layer 70, provides light extraction efficiency that is improved when compared with that of a conventional light emitting device by about 5%. That is, if the electrode is divided into first and second electrodes such that only the first electrode directly makes contact with the first conductive semiconductor layer, the light extraction efficiency is improved when compared with the case in which the electrode directly makes contact with the first conductive semiconductor layer in a conventional manner.

The conductive support substrate 60 may include electric conductive material. For instance, the conductive support substrate 60 may include at least one of titanium (Ti), chrome (Cr), nickel(Ni), aluminum (Al), platinum (Pt), gold (Au) or electric conductive semiconductor material. Although not shown in the drawings, a reflective layer including Ag or Al and an ohmic contact layer making ohmic contact with the second conductive semiconductor layer 50 can be formed on the conductive support substrate 60.

The light emitting structure may include a GaN-based semiconductor layer. The light emitting structure can be formed by using GaN, InGaN, AIGaN, or InAlGaN.

For instance, the first conductive semiconductor layer 30 includes an n type semiconductor layer. The first conductive semiconductor layer 30 may include semiconductor material having the compositional formula of InₓAl_{y}Ga_{1-x-y}N (0≤x≤1, 0≤y≤1, 0≤x+y≤1), such as InAlGaN, GaN, AlGaN, InGaN, AllnN, AIN, or InN. In addition, the first conductive semiconductor layer 30 may be doped with n type dopant such as Si, Ge or Sn.

Electrons (or holes) injected through the first conductive semiconductor layer 30 couple holes (or electrons) injected through the second conductive semiconductor layer 50 at the active layer 40, so that the active layer 40 emits the light based on the band gap difference of the energy band according to material of the active layer 40.

The active layer 40 may have a single quantum well structure, a multiple quantum well (MQW) structure, a quantum wire structure or a quantum dot structure, but the embodiment is not limited thereto.

The active layer 40 may include semiconductor material having the compositional formula of InₓAl_{y}Ga_{1-x-y}N (0≤x≤1, 0≤y≤1, 0≤x+y≤1). If the active layer 40 has the MQW structure, the active layer 40 has a stack structure including a plurality of well layers and a plurality of barrier layers. For instance, the active layer 40 may have a stack structure of an InGaN well layer/a GaN barrier layer.

A clad layer (not shown) doped with the n type or p type dopant can be formed on and/or under the active layer 30. The clad layer may include an AlGaN layer or an lnAlGaN layer.

The second conductive semiconductor layer 50, for example, includes a p type semiconductor layer. The second conductive semiconductor layer 50 may include semiconductor material having the compositional formula of InₓAl_{y}Ga_{1-x-y}N (0≤x≤1, 0≤y≤1, 0≤x+y≤1), such as InAlGaN, GaN, AlGaN, InGaN, AllnN, AIN, or InN. In addition, the second conductive semiconductor layer 50 may be doped with p type dopant such as Mg, Zn, Ca, Sr, or Ba.

In contrast, the first conductive semiconductor layer 30 may include a p type semiconductor layer and the second conductive semiconductor layer 50 may include an n type semiconductor layer. In addition, a third conductive semiconductor layer (not shown) including an n type or a p type semiconductor layer can be formed on the second conductive semiconductor layer 50. Thus, the light emitting structure may have one of NP, PN, NPN or PNP junction structures. In addition, the conductive dopant can be uniformly or non-uniformly doped in the first and second conductive semiconductor layers 30 and 50. That is, the light emitting structure may have various structures and the embodiment is not limited thereto.

In other words, the light emitting structure including the first conductive semiconductor layer 30, the active layer 40 and the second conductive semiconductor layer 50 can be variously modified without limitation.

The passivation layer 70 may include electric insulating material having high light transmittance. The passivation layer 70 surrounds the lateral sides and the top surface of the light emitting structure to protect the light emitting structure from the external impact, moisture, or impurities. For instance, the passivation layer 70 may include SiO_{2,} Al₂O_{3,} SiN or a combination thereof.

The first and second electrodes 91 and 92 may include the same material or different materials. For instance, the first electrode 91 may include material that comes into ohmic contact with the first conductive semiconductor layer 30, such as Cr or Ni. In addition, the second electrode 92 may include at least one of Cr, Al, Ag, Ni, or Au and can be prepared in the form of a stack structure including Cr/Al/Ni/Au or Cr/Ag/Ni/Au.

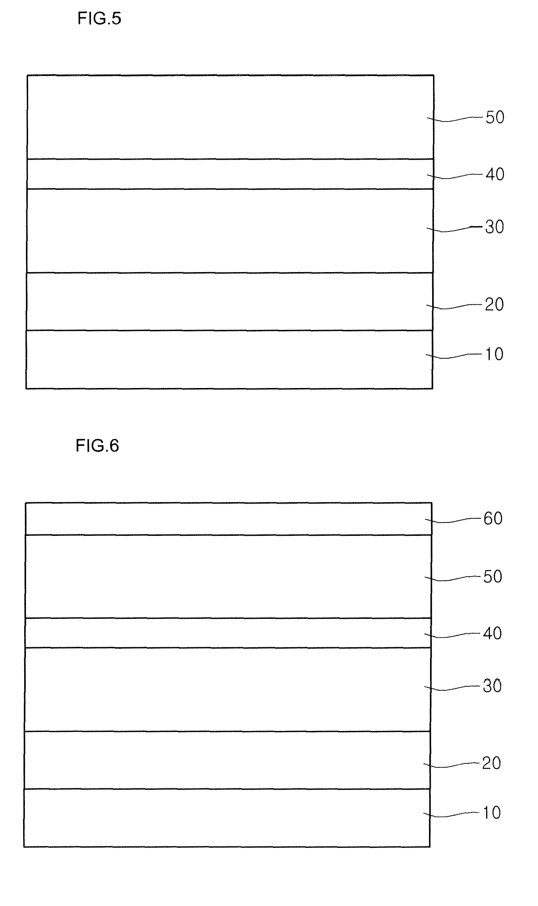

FIGS. 5 to 13 are sectional views showing a method for manufacturing the light emitting device according to the embodiment.

Referring to FIG. 5, an undoped GaN layer 20, the first conductive semiconductor layer 30, the active layer 40 and the second conductive semiconductor layer 50 are formed on the growth substrate 10.

The growth substrate 10 may include at least one of sapphire, SiC, Si, GaAs, ZnO, MgO, GaN, Glass or Ga₂O₃. The undoped GaN layer 20 is grown by injecting trimethyl gallium (TMGa) gas into the chamber together with hydrogen gas and ammonia gas.

In addition, a buffer layer can be formed between the growth substrate 10 and the undoped GaN layer 20. The buffer layer may include stack structure, such as AllnN/GaN, InₓGa₁₋ₓN/GaN, or Alₓln_{y}Ga_{1-x-y}N/lnₓGa₁₋ₓN/GaN. For instance, the buffer layer can be grown by injecting trimethyl gallium (TMGa) gas, trimethyl indium (TMln) gas and trimethyl aluminum (TMAI) gas into the chamber together with hydrogen gas and ammonia gas.

The first conductive semiconductor layer 30 can be grown by injecting TMGa gas and SiH₄ gas including n type impurities (for example, Si) into the chamber together with hydrogen gas and ammonia gas. In addition, the active layer 40 and the second conductive semiconductor layer 50 are formed on the first conductive semiconductor layer 30.

The active layer 40 may have a single quantum well structure or a multiple quantum well (MQW) structure. For instance, the active layer 40 may have a stack structure including an InGaN well layer and a GaN barrier layer.

The second conductive semiconductor layer 50 can be grown by injecting TMGa gas and (EtCp₂Mg){Mg(C₂H₅C₅H₄)₂} gas including p type impurities (for example, Mg) into the chamber together with hydrogen gas and ammonia gas.

Referring to FIG. 6, the conductive support substrate 60 is formed on the second conductive semiconductor layer 50 through an electroplating process or a wafer bonding process.

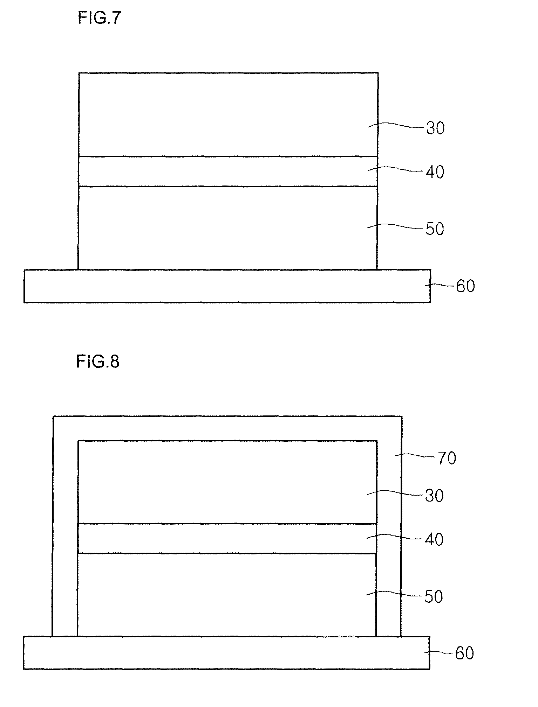

Referring to FIG. 7, the growth substrate 10 and the undoped GaN layer 20 are separated from the light emitting structure including the conductive support substrate 60 through an etching process or a laser lift off process. Then, an isolation etching process is performed to separate the chips.

Referring to FIG. 8, the passivation layer 70 is formed such that the light emitting structure formed on the conductive support substrate 60 can be surrounded by the passivation layer 70.

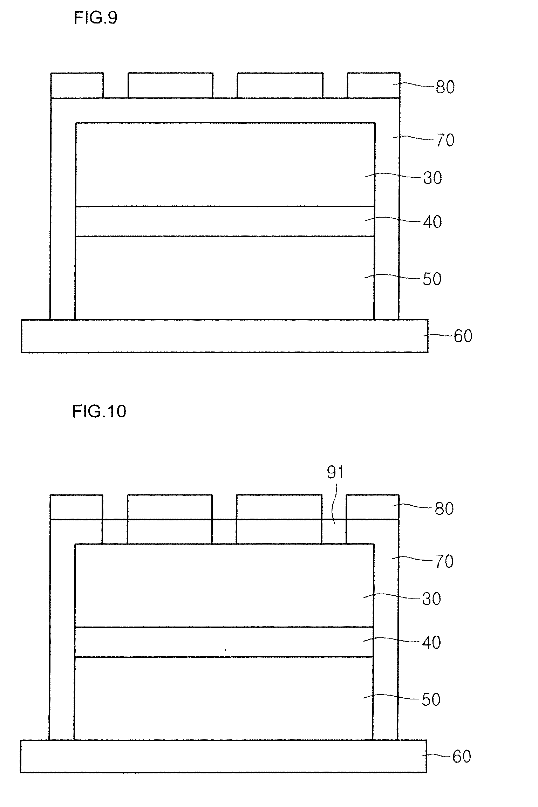

Referring to FIGS. 9 to 11, a first mask pattern 80 is formed on the passivation layer 70, and then the passivation layer 70 formed on the first conducive semiconductor layer 30 is selectively removed by using the first mask pattern 80 as a mask. Then, the first electrode 91 is formed on a region of the first conductive semiconductor layer 30 which is exposed as the passivation layer 70 has been removed.

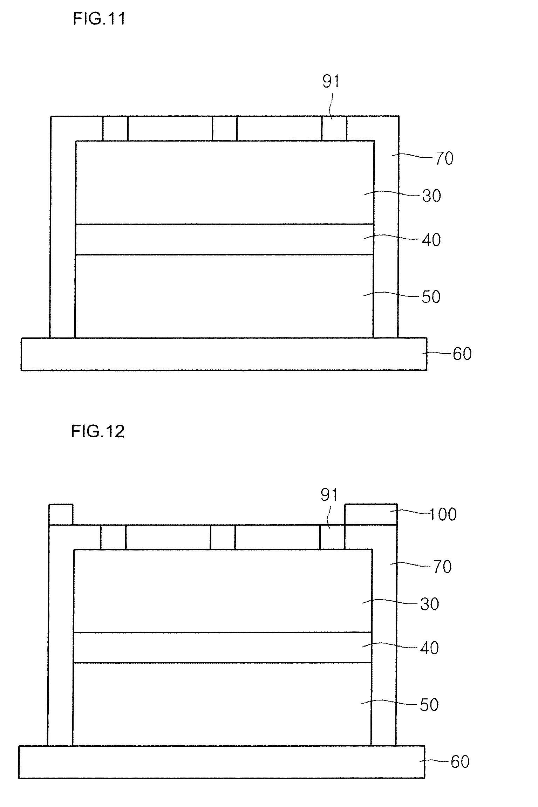

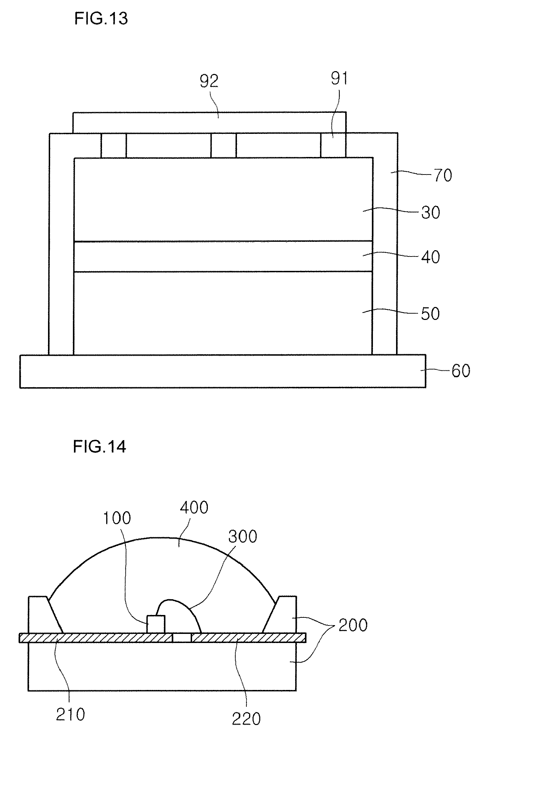

Referring to FIGS. 12 and 13, a second mask pattern 100 is formed on the passivation layer 70 and the second electrode 92 is formed on the first electrode 91 and a predetermined region of the passivation layer 70 where the second mask pattern 100 is not formed.

As a result, the light emitting device as shown in FIGS. 1 to 4 may be manufactured.

FIG. 14 is a view showing a light emitting device package including the light emitting device according to the embodiments.

Referring to FIG. 14, the light emitting device package includes a body 200, first and second electrode layers 210 and 220 formed on the body 200, the light emitting device 100 provided on the body 200 and electrically connected to the first and second package electrode layers 210 and 220, and a molding member 400 that surrounds the light emitting device 100.

The body 200 may include silicon, synthetic resin or metallic material. An inclined surface may be formed around the light emitting device 100.

The first and second package electrode layers 210 and 220 are electrically isolated from each other to supply power to the light emitting device 100. In addition, the first and second package electrode layers 210 and 220 reflect the light emitted from the light emitting device 100 to improve the light efficiency and dissipate heat generated from the light emitting device 100 to the outside.

The light emitting device 100 can be installed on the body 200 or on the first and second package electrode layers 210 and 220.

The light emitting device 100 can be electrically connected to the first package electrode 210 and/or the second package electrode 220 through a wire 300. A vertical type light emitting device is disclosed in the embodiment. In this case, the light emitting device 100 is electrically connected to the second package electrode 220 through the wire 300. As shown in FIG. 4, if two circular sections 92a of the second electrode 92 are provided, two wires 300 are used to electrically connect the light emitting device 100 to the second package electrode layer 220.

The molding member 400 surrounds the light emitting device 100 to protect the light emitting device 100. In addition, the molding member 400 may include phosphors to change a wavelength of light emitted from the light emitting device 100.

A plurality of light emitting device packages according to the embodiment may be arrayed on a substrate, and an optical member including a light guide plate, a prism sheet, and a diffusion sheet may be provided on the optical path of the light emitted from the light emitting device package. The light emitting device package, the substrate, and the optical member may serve as a backlight unit or a lighting unit. For instance, the lighting system may include a backlight unit, a lighting unit, an indicator, a lamp, or a streetlamp.

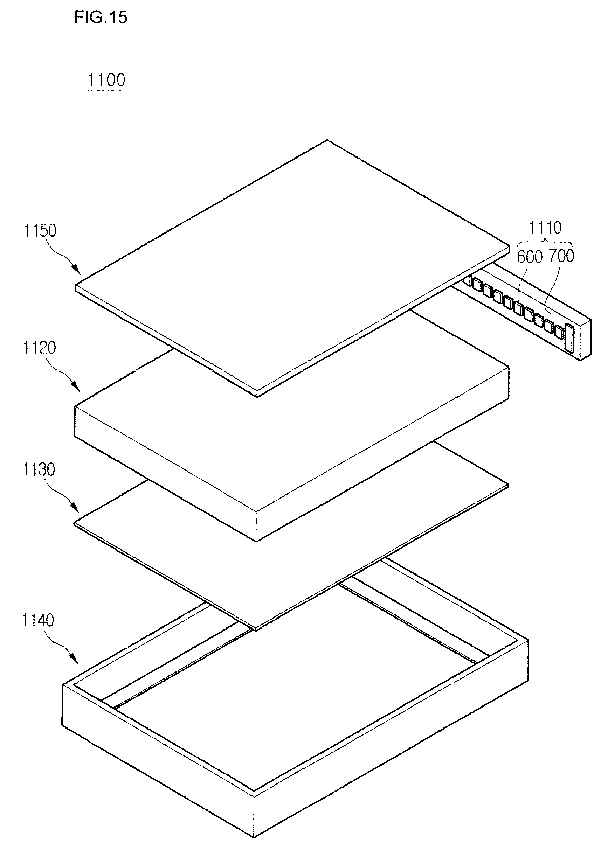

FIG. 15 is an exploded perspective view showing a backlight unit 1100 including a light emitting device package according to the embodiment. The backlight unit 1100 shown in FIG. 15 is an example of a lighting system and the embodiment is not limited thereto.

Referring to FIG. 15, the backlight unit 1100 includes a bottom frame 1140, a light guide member 1120 installed in the bottom frame 1140, and a light emitting module 1110 installed at one side or on the bottom surface of the light guide member 1120. In addition, a reflective sheet 1130 is disposed under the light guide member 1120.

The bottom frame 1140 has a box shape having a top surface being open to receive the light guide member 1120, the light emitting module 1110 and the reflective sheet 1130 therein. In addition, the bottom frame 1140 may include metallic material or resin material, but the embodiment is not limited thereto.

The light emitting module 1110 may include a substrate 700 and a plurality of light emitting device packages 600 installed on the substrate 700. The light emitting device packages 600 provide the light to the light guide member 1120. According to the light emitting module 1110 of the embodiment, the light emitting device packages 600 are installed on the substrate 700. However, it is also possible to direct install the light emitting device 100 according to the embodiment.

As shown in FIG. 15, the light emitting module 1110 is installed on at least one inner side of the bottom frame 1140 to provide the light to at least one side of the light guide member 1120.

In addition, the light emitting module 1110 can be provided in the bottom frame 1140 to provide the light toward the bottom surface of the light guide member 1120. Such an arrangement can be variously changed according to the design of the backlight unit 1100 and the embodiment is not limited thereto.

The light guide member 1120 is installed in the bottom frame 1140. The light guide member 1120 converts the light emitted from the light emitting module 1110 into the surface light to guide the sur6face light toward a display panel (not shown).

The light guide member 1120 may include a light guide plate. For instance, the light guide plate can be manufactured by using acryl-based resin, such as PMMA (polymethyl methacrylate), PET (polyethylene terephthalate), PC (polycarbonate), COC or PEN (polyethylene naphthalate) resin.

An optical sheet 1150 may be provided over the light guide member 1120.

The optical sheet 1150 may include at least one of a diffusion sheet, a light collection sheet, a brightness enhancement sheet, or a fluorescent sheet. For instance, the optical sheet 1150 has a stack structure of the diffusion sheet, the light collection sheet, the brightness enhancement sheet, and the fluorescent sheet. In this case, the diffusion sheet uniformly diffuses the light emitted from the light emitting module 1110 such that the diffused light can be collected on the display panel (not shown) by the light collection sheet. The light output from the light collection sheet is randomly polarized and the brightness enhancement sheet increases the degree of polarization of the light output from the light collection sheet. The light collection sheet may include a horizontal and/or vertical prism sheet. In addition, the brightness enhancement sheet may include a dual brightness enhancement film and the fluorescent sheet may include a transmittive plate or a transmittive film including phosphors.

The reflective sheet 1130 can be disposed under the light guide member 1120. The reflective sheet 1130 reflects the light, which is emitted through the bottom surface of the light guide member 1120, toward the light exit surface of the light guide member 1120.

The reflective sheet 1130 may include resin material having high reflectivity, such as PET, PC or PVC resin, but the embodiment is not limited thereto.

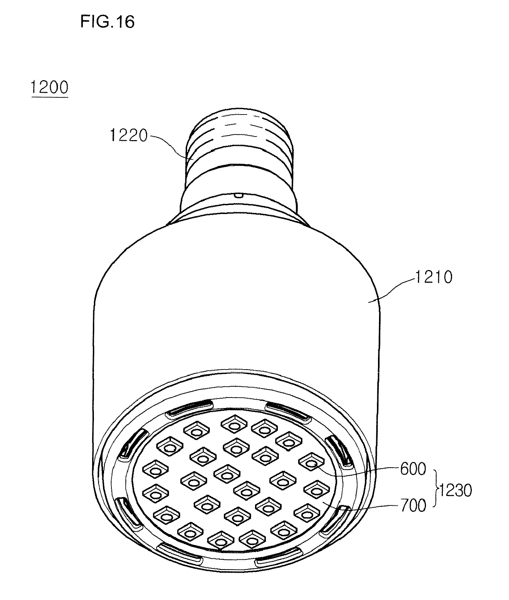

FIG. 16 is a perspective view showing a lighting unit 1200 including the light emitting device or the light emitting device package according to the embodiment. The lighting unit 1200 shown in FIG.16 is an example of a lighting system and the embodiment is not limited thereto.

Referring to FIG. 16, the lighting unit 1200 includes a case body 1210, a light emitting module 1230 installed in the case body 1210, and a connection terminal 1220 installed in the case body 1210 to receive power from an external power source.

Preferably, the case body 1210 includes material having superior heat dissipation property. For instance, the case body 1210 includes metallic material or resin material.

The light emitting module 1230 may include a substrate 700 and at least one light emitting device package 600 installed on the substrate 700. According to the embodiment, the light emitting device package 600 is installed on the substrate 700. However, it is also possible to direct install the light emitting device 100 according to the embodiment.

The substrate 700 includes an insulating member printed with a circuit pattern. For instance, the substrate 700 includes a PCB (printed circuit board), an MC (metal core) PCB, an F (flexible) PCB, or a ceramic PCB.

In addition, the substrate 700 may include material that effectively reflects the light. The surface of the substrate 300 can be coated with a color, such as a white color or a silver color, to effectively reflect the light.

At least one light emitting device package 600 according to the embodiment can be installed on the substrate 700. Each light emitting device package 300 may include at least one LED (light emitting diode). The LED may include a colored LED that emits the light having the color of red, green, blue or white and a UV (ultraviolet) LED that emits UV light.

The LEDs of the light emitting module 1230 can be variously arranged to provide various colors and brightness. For instance, the white LED, the red LED and the green LED can be arranged to achieve the high color rendering index (CRI). In addition, a fluorescent sheet can be provided in the path of the light emitted from the light emitting module 1230 to change the wavelength of the light emitted from the light emitting module 1230. For instance, if the light emitted from the light emitting module 1230 has a wavelength band of blue light, the fluorescent sheet may include yellow phosphors. In this case, the light emitted from the light emitting module 1230 passes through the fluorescent sheet so that the light is viewed as white light.

The connection terminal 1220 is electrically connected to the light emitting module 1230 to supply power to the light emitting module 1230. Referring to FIG. 16, the connection terminal 1220 has a shape of a socket screw-coupled with the external power source, but the embodiment is not limited thereto. For instance, the connection terminal 1220 can be prepared in the form of a pin inserted into the external power source or connected to the external power source through a wire.

According to the lighting system as mentioned above, at least one of the light guide member, the diffusion sheet, the light collection sheet, the brightness enhancement sheet and the fluorescent sheet is provided in the path of the light emitted from the light emitting module, so that the desired optical effect can be achieved.

As described above, since the lighting system includes the light emitting device or the light emitting device package having the superior light extraction efficiency, the light efficiency can be improved.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting device comprising:
a light emitting structure including a first conductive semiconductor layer, a second conductive semiconductor layer, and an active layer between the first and second conductive semiconductor layers;
a passivation layer at least partially on the light emitting structure;
a first electrode on the first conductive semiconductor layer; and
a second electrode on the first electrode and the passivation layer.

2. The light emitting device of claim 1, wherein the first electrode has a first area and the second electrode has a second area that is larger than the first area.

3. The light emitting device of claim 1, wherein the first electrode includes a plurality of electrodes spaced apart from each other, and the second electrode electrically connects the plurality of electrodes with each other.

4. The light emitting device of claim 1, further comprising a conductive support substrate under the light emitting structure.

5. The light emitting device of claim 4, wherein at least some parts of the conductive support substrate, the light emitting structure, the first electrode, and the second electrode overlap with each other in the vertical direction.

6. The light emitting device of claim 4, wherein at least some parts of the conductive support substrate, the light emitting structure, the passivation layer, and the second electrode overlap with each other in the vertical direction.

7. The light emitting device of claim 3, wherein at least a part of the plurality of electrodes are aligned on a same horizontal plane with the passivation layer.

8. The light emitting device of claim 1, wherein the first electrode makes contact with the passivation layer.

9. The light emitting device of claim 1, wherein the passivation layer includes electric insulating material having light transmission property.

10. The light emitting device of claim 1, wherein the passivation layer includes at least one selected from the group consisting of SiO_{2,} Al₂O_{3,} SiN and a combination thereof.

11. The light emitting device of claim 1, wherein at least a part of the second electrode is spaced apart from the first conductive semiconductor layer by the passivation layer.

12. The light emitting device of claim 1, wherein the second electrode includes a plurality of circular sections making contact with the first electrode and a linear section connecting the circular sections.

13. A light emitting device package comprising:
a body;
first and second package electrode layers on the body;
a light emitting device as claimed in any one of claims 1 to 12 electrically connected to the first and second package electrode layers on the body; and
a molding member surrounding the light emitting device on the body.

14. A lighting system comprising:
a light emitting module including a substrate and at least one light emitting device as claimed in any one of claims 1 to 12 installed on the substrate as a light source.

15. A method of manufacturing a light emitting device, the method comprising:
forming a light emitting structure on a substrate;
forming a passivation layer on the light emitting structure;
selectively removing the passivation layer on the light emitting structure;
forming a first electrode on the light emitting structure at least at the selectively removed portion of the passivation layer; and
forming a second electrode on the first electrode and the passivation layer.
